(19)

Europäisches
Patentamt
European
Patent Office
Office européen
des brevets

(11) **EP 2 299 468 A1**

(12) **EUROPEAN PATENT APPLICATION**

(43) Date of publication:
23.03.2011 Bulletin 2011/12

(51) Int Cl.:
*H01J 37/26* (2006.01)

(21) Application number: 09170780.2

(22) Date of filing: 20.09.2009

(84) Designated Contracting States:
AT BE BG CH CY CZ DE DK EE ES FI FR GB GR HR HU IE IS IT LI LT LU LV MC MK MT NL NO PL PT RO SE SI SK SM TR
Designated Extension States:
AL BA RS

(71) Applicant: Universiteit Antwerpen
2000 Antwerpen (BE)

(72) Inventor: Van Dyck, Dirk
2630 Aartselaar (BE)

(74) Representative: Wauters, Davy Erik Angelo et al
DenK IP bvba
Pastoor Ceulemansstraat 3
3191 Schiplaken (Hever) (BE)

(54) **Methods and systems for using phase plates**

(57) A method (100) and system are described for obtaining wave function data from microscope measurements. The method comprises receiving (110) microscope image intensity data acquired using a phase inducing means whereby the data are acquired over predetermined image recording times and whereby a phase shift induced by the phase inducing means is kept constant. The method furthermore comprises extracting (130) wave function data from the microscope image intensity data acquired over predetermined image recording times, whereby the predetermined image recording times are function of a phase shift angle θ. A corresponding transmission microscope and corresponding computer related products also are disclosed.

FIG. 1

## Description

### Field of the invention

The invention relates to the field of microscopy, e.g. electron microscopy. More particularly, the present invention relates to methods and systems for extracting wave function information using phase plates, such as for example in transmission electron microscopy.

### Background of the invention

The importance of phase plates for phase contrast imaging has been amply demonstrated in optics. Already in the sixties, attempts have been made to introduce phase plates in a TEM. However the problem in electron microscopy is that a phase plate typically consists of a very thin layer that has to be traversed by the electron, and, because of the strong interaction of electrons with matter, the effect of the plate on the phase and amplitude of the outgoing electrons is very difficult to control. Earlier 2000, a carbon film was used as a phase plate. The thickness of carbon film was around 30nm. A hole in the center of the carbon film allowed that the scattered beam has shifted $\pi/2$. Besides problems with absorption contrast, caused by attenuation of scattered beam through the carbon film, also problems with charging occurred.

Recently however, using advanced methods of nanotechnology, it becomes possible to control the dimensions and quality of the phase plates to such an extent that the amplitude of the electron wave is less affected and the phase can be controlled. Reported examples of phase plates are electrostatic phase plates. In one example a phase plate comprising a multilayer structure is suggested.

Several groups have reported regarding phase plates for phase contrast enhancement. Alloyeau et al. in their abstract "Contrast Transfer Function Design by an Electrostatic Phase Plate for contrast enhancement in transmission electron microscopy" and Hsieh et al. in their abstract "Contrast Transfer Function Design by an Electrostatic Phase Plate" in Microsc. Microanal 13 (2007) describe the fabrication of an electrostatic phase plate.

Nagayama et al have also reported the use of phase plates for electron microscopy in Biophys. Rev. (2009) p37-42.

The availability of phase plates for electron microscopes opens possibilities which have not been completely explored yet.

### Summary of the invention

It is an object of embodiments of the present invention to provide good methods and systems for obtaining wave function information, based on microscopy such as electron microscopy using a variable phase inducing means. It is an advantage of embodiments according to the present invention that methods and systems are provided that allow retrieving the whole wave function, even for thicker objects. It is an advantage of embodiments according to the present invention that methods and systems are provided for obtaining wave function data, the methods and systems being robust and easy to implement. It is an advantage of embodiments according to the present invention that efficient and accurate methods and systems for obtaining wave function information are provided. It is an advantage of embodiments according to the present invention that wave function information can be obtained by relatively simple processing of image intensities obtained via microscopy, e.g. electron microscopy, using a variable phase inducing means, e.g. a set of phase plates or a variable phase plate such as for example a tuneable variable phase plate. The above objective is accomplished by a method and device according to the present invention. The present invention relates to a method for obtaining wave function data from microscope measurements, the method comprising receiving microscope image intensity data acquired using a variable phase inducing means, the microscope image intensity data taking into account a image intensity data recorded for a plurality of different induced phases, and extracting wave function data from the microscope image intensity data. In a preferred embodiment, the microcope image intensity data are electron microcope image intensity data. It is an advantage of embodiments according to the present invention that wave function data can be derived from microscope measurements by the use of a variable phase inducing means. Such data may be used e.g. in the processing of electron microscope data for deriving predetermined information.

The received microscope image intensity data may comprise image intensity data recorded for a plurality of different induced phases, wherein said extracting comprises first combining the plurality of image intensity data recorded for different induced phases.

Extracting wave function data may comprise deriving the wave function data from the microscope image intensity data by distinguishing a component related to the variable phase inducing means from a component comprising the wave function data. The component related to the variable phase inducing means may be a component being function of an aperture function of the phase inducing means.

Extracting wave function data can be obtained by applying a high pass filter on the acquired image intensity data. It is an advantage of embodiments according to the present invention that extraction of the information can be easily performed using conventional techniques such as applying a high pass filter.

Receiving microscope image intensity data acquired using a variable phase inducing means may comprise receiving, for each phase, image intensity data weighted by applying a phase dependent image intensity recording time.

The image recording times may be goniometric functions of the phase shift angle θ induced by the variable phase inducing means. It is an advantage of embodiments according to the present invention that the image recording times required for obtaining the correct microscope image intensity data can be easily determined. Receiving microscope image intensity data may comprise acquiring transmission microscope image intensity data using a variable phase inducing means.

The phase inducing means may be a variable electrostatic phase plate.

The present invention relates to an image processing system for extracting wave function data, the image processing system comprising an input port adapted for receiving microscope image intensity data acquired using a variable phase inducing means, the microscope image intensity data taking into account image intensity data for a plurality of different phases, and a processor for extracting wave function data from the microscope image intensity data acquired.

The present invention furthermore relates to a transmission electron microscope for obtaining electron microscope images, the transmission electron microscope comprising a variable phase inducing means for inducing a variably settable phase shift in an aperture of the variable phase inducing means over a phase shift angle, a controller for controlling acquisition of electron microscope image intensity data using a variable phase inducing means, the electron microscope image intensity data taking into account image intensity data for a plurality of different induced phases, and an image processing system as described above. In addition thereto the present invention also may relate to an optical microscope comprising a variable phase inducing means for inducing a variably settable phase shift in an aperture of the variable phase inducing means over a phase shift angle, a controller for controlling acquisition of microscope image intensity data using a variable phase inducing means, the microscope image intensity data taking into account image intensity data for a plurality of different induced phases, and an image processing system as described above.

The present invention also relates to a computer program product for performing, when implemented on a computing device, a method as described above.

The present invention also relates to a machine readable data storage device storing such a computer program product or to the transmission of such a computer program product over a local or wide area telecommunications network.

Particular and preferred aspects of the invention are set out in the accompanying independent and dependent claims. Features from the dependent claims may be combined with features of the independent claims and with features of other dependent claims as appropriate and not merely as explicitly set out in the claims. These and other aspects of the invention will be apparent from and elucidated with reference to the embodiment(s) described hereinafter.

**Brief description of the drawings**

FIG. 1 is a flow chart of an exemplary method for obtaining wave function information according to an embodiment of the present invention.

FIG. 2 is a schematic representation of the aperture function for a phase plate as can be used in an embodiment of the present invention.

FIG. 3 is a schematic representation of an image processor for obtaining wave function information according to an embodiment of the present invention.

FIG. 4 is a schematic representation of a transmission electron microscope according to an embodiment of the present invention.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

**Detailed description of illustrative embodiments**

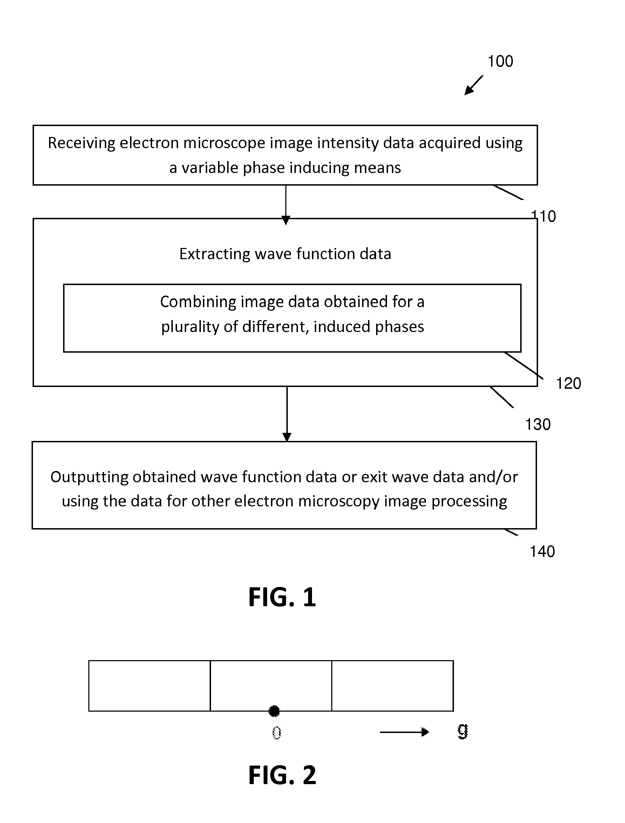

In a first aspect, the present invention relates to a method for obtaining wave function data from electron microscope measurements or optical coherent radiation measurements. The method may especially suitable for use with electron microscope measurements. The obtained wave function data may be used for processing measurements, e.g. electron microscope measurements, thus allowing to extract particular information, such as for example to reconstruct an exit wave for an object which then may be used for reconstructing the object upon imaging. Nevertheless, the invention is not limited thereto but only limited by the claims. The method according to embodiments of the present invention comprises receiving microscope image intensity data, e.g. electron microscope image intensity data, acquired using a variable phase inducing means. Such a variable phase inducing means may be a set of phase plates or a variable phase plate, like for example a continuous variable phase plate. The acquired image intensity data thereby takes into account a plurality of image intensity data recorded for different induced phases by the variable phase inducing means. It may be the result of combining such image intensity data recorded for a plurality of different induced phases or it may be received as a set of separate image intensity data, each part of the set of image intensity data recorded for a different induced phase. In the latter case an additional combining step may be performed. As will be shown, advantageously for each phase the corresponding image intensity data may be given a particular weight. In some embodiments, this weight can be provided by recording the image intensity data for a predetermined time, being function of the phase θ. The method furthermore comprises extracting wave function data from the received image intensity data. The obtained wave function data advantageously is the complete wave function. It is an advantage of embodiments according to the present invention that wave function data, advantageously the complete wave function, can be efficiently and rather easily derived from microscopy intensity measurements, e.g. electron microscopy intensity measurements. By way of illustration, embodiments of the present invention not being limited thereto, standard and optional steps of a method for obtaining wave function data are illustrated in FIG. 1.

The method 100 for obtaining wave function data comprises receiving 110 microscope image intensity data, e.g. electron microscope image intensity data, acquired using a variable phase inducing means, e.g. a set of phase plates or a variable phase plate. The microscope image intensity data, according to embodiments of the present invention, takes into account image intensity data recorded for a plurality of different induced phases, induced by the variable phase inducing means. Such receiving 110 may be receiving of previously recorded image intensity data, for each phase separately or combined, via an input port. Alternatively, the microscope image intensity data also may be received by acquiring of the data using a microscope comprising a variable phase inducing means. Examples of obtaining such data may include obtaining separate image intensity data for different induced phases by recording image intensity data for a plurality of different phase plates, each received separately. In another, more advantageous, embodiment the image intensity data for different induced phases may be received in a combined, e.g. after integration, and obtaining then may comprise recording the data in a single experiment whereby the different phases are introduced by tuning a variable phase plate, such that the received image intensity data is received as integrated data.

In advantageous embodiments, the image intensity data for a given phase may be given a certain weight dependent on the phase. Such a weight may be introduced during processing steps for extracting the wave function by providing weight factors to a set of separate image intensity data. Nevertheless, in one advantageous embodiment, the weight may be inherently provided in the recorded image intensity data, e.g. by adjusting the recording time for image intensity data corresponding to each of the phases at which data is recorded. The image intensity data at one phase requiring a higher weight then typically may be recorded over a longer recording time than image intensity at another phase requiring less weight. As will be shown for one example, predetermined recording times as function of the phase shift angle θ may be used. In one example, the image intensity data that is used for a given phase thus may be image intensity recorded over a recording time being proportional to cosθ and image intensity recorded over a recording time being proportional to sinθ, resulting in a fixed weight factor for a fixed phase shift angle, i.e. for image intensity data corresponding with a fixed phase shift angle.

$$t_{rec1} \propto \cos \theta$$
$$t_{rec2} \propto \sin \theta$$

[1]

In some examples, the range of phase angles of interest, preferably the range $[0, 2\pi]$, may be samples in different angular increments, In some examples angular increments may be in the order of a few degrees resulting in between 10 to 100 intervals.

The method also comprises extracting 130 wave function data, advantageously the whole wave function, from the image intensity data. Where the received data comprises receiving separate image intensity data for different phases, the method 100 furthermore advantageously may comprise combining 120 the different image intensity data for different phases, advantageously each with their own weight factor. Combining the image intensity data in preferred embodiments may be integrating the image intensity data, optionally multiplied with their weight factor, over all possible phases. Combining may be a discrete summation of the different contributions at different phases, semi-discrete summation or, if continuous data would be available, continuous integration. The more numerous the measurements at different phases, the more accurate the result can be. In some advantageous embodiments, the combination of the different image intensity data may have already been performed during the imaging process by subsequent measurement of the image intensity data for the different phases. Also in this case, the weighting factors may have been taken into account experimentally as described above. In this way combined weighted image intensity data can be directly measured, e.g. by varying the variable phase inducing means over a plurality of phases representative for a phase range of interest, typically $[0,2\pi[$. In some examples, the required voltage for covering this range via for example an electrostatic phase plate may vary depending on the design of such an electrostatic phase plate. The total recording time for recording the image intensities if CCD's are used typically is of the order of 1 second, although embodiments of the present invention are not limited thereby. The total recording time may depend on the source used and on the number of imaging particles obtained. The latter may be selected so as to have a sufficient signal to noise ratio. Extracting wave function data may comprise distinguishing a component related to the phase inducing means from a component comprising the wave function. The component related to the phase inducing means may be a component being function of an aperture function of the phase inducing means. Separation between the components can for example be performed by applying a high pass filter on the acquired image intensity data, such as for example a Laplacean filter. In one example the processed image intensity data may be a function of the wave function and an expression dependent on the aperture function of the phase inducing means, i.e.

$$I_{processed} \propto f_1\left(\psi(\overline{r}), a(\overline{r})\right) \qquad\qquad [2]$$

whereby $\alpha(\overline{r})$ is the Fourier transform of the aperture function of the phase inducing means.

In one particular embodiment, the combined contributions of image intensity data integrated over the phase angle, are function of the wave function and the aperture function as follows

$$\int_0^{2\pi} I(\theta)\cos\theta d\theta = \mathrm{Re}\left(\left(\psi(\overline{r})*a(\overline{r})\right)^*\left(\psi(\overline{r})-\left(\psi(\overline{r})*a(\overline{r})\right)\right)\right) \qquad\qquad [3]$$

$$\int_0^{2\pi} I(\theta)\cos\theta d\theta = \mathrm{Im}\left(\left(\psi(\overline{r})*a(\overline{r})\right)^*\left(\psi(\overline{r})-\left(\psi(\overline{r})*a(\overline{r})\right)\right)\right)$$

whereby $\alpha(\overline{r})$ is the Fourier transform of the aperture function of the phase inducing means and $\Psi(\overline{r})$. Based on the relation between the integrated image intensity and the function of the wave function and aperture function, wave function data can be extracted.

In embodiments according to the present invention, advantageously, the whole wave function in the image plane can be derived.

In an optional step, when the whole wave function in the image plane is derived, the method also comprises determining 140 an exit wave for the imaged object. Such information may for example be used for reconstruction of objects, such as for obtaining an atomic structure of an object.

The method 100 furthermore optionally may comprise outputting 150 the obtained wave function data or exit wave data and/or using such data for other electron microscopy image processing such as for example image analysis or tomography.

It is an advantage of embodiments according to the present invention that methods and systems are provided that filter out incoherent backgrounds due to inelastic scattering in the object and in the phase inducing means since they are independent from $\theta$ and cancel in the integration. Where necessary the sensitivity to noise may be taken into account. It is also clear that, when the central beam would be partly absorbed in the phase inducing means so that only a fraction of $\langle\Psi\rangle$ is transmitted, the final result is only affected by a constant factor. In this way the reconstructed wave functions will not suffer from artefacts such as the Stobbs factor.

In some embodiments according to the present invention, the variable phase inducing means, e.g. a variable phase plate or set of phase plates, may be selected to have a central active part that is sufficiently small in order not to influence the small spatial frequencies that are relevant for large structures such as macromolecules. Furthermore in some embodiments according to the present invention, diffraction effects of the central beam on the edges of the central area should be avoided by arranging or manufacturing the variable phase inducing means such that no edges of the interacting part of the phase inducing means cross the central beam. The interaction region thus must also be sufficiently large. Typically the size of the interacting portion thus may be chosen intermediate.

Without wishing to be bound by theory, features and advantages of some embodiments of the present invention could be explained based on the following theoretical principles and algorithm, embodiments of the present invention not being limited thereto. Whereas a particular shape of the phase inducing means, e.g. a phase plate, is used in the following description, embodiments of the invention are not limited thereby. Whereas a particular mathematical formulation is used, embodiments of the present invention are not limited thereto.

A disk-like phase plate is considered being a foil with a central, active area, that is put in the focal plane of the objective lens to shift the phase of the central beam ($\bar{g} = 0$) in diffraction space over a phase angle θ with respect to the other beams ($\bar{g} \neq 0$).

The aperture function of this central area can then be defined as

$$A(\bar{g}) = 1 \qquad \text{for } \bar{g} \text{ in the central area}$$
$$A(\bar{g}) = 0 \qquad \text{for } \bar{g} \text{ outside the central area} \tag{4}$$

Consider now an electron wave $\Psi(\bar{g})$ that crosses the phase plate. After transmission, the electron wave then becomes

$$\varphi(\bar{g},0) = \psi(\bar{g})A(\bar{g})e^{i\theta} + \psi(\bar{g})[1 - A(\bar{g})] \tag{5}$$

It is to be noticed that the same result can be obtained with the central area of the phase plate inactive and the outer region shifting the phase of the electron wave over -θ.

Fourier transforming $\Psi(\bar{g})$ in real space then yields

$$\varphi(\bar{r},0) = [\psi(\bar{r}) * a(\bar{r})e^{i\theta}] + \psi(\bar{r}) - \psi(\bar{r}) * a(\bar{r}) \tag{6}$$

where $a(\bar{r})$ is the Fourier transform of $A(\bar{g})$ and * is a convolution product.

If the central area of the phase plate is very small it acts as a low pass filter so that the convolution product with $a(\bar{r})$ in real space acts as an averaging over an area, the size of which is inversely related to the size of $A(\bar{g})$.

This averaging can be denoted as

$$\langle \psi(\bar{r}) \rangle = \psi(\bar{r}) * a(\bar{r}) \tag{7}$$

If one defines

$$\delta(\bar{r}) = \psi(\bar{r}) - \langle \psi(\bar{r}) \rangle \tag{8}$$

or

$$\langle \psi(\bar{r}) \rangle = \psi(\bar{r}) + \delta(\bar{r}) \tag{9}$$

with

$$\left\langle \delta\!\left(\overline{r}\right)\right\rangle = \delta\!\left(\overline{r}\right) * a\!\left(\overline{r}\right) = 0 \qquad [10]$$

the Fourier transforming $\varphi(\overline{g})$ becomes

$$\varphi\!\left(\overline{r},\theta\right) = \left\langle \psi\!\left(\overline{r}\right)\right\rangle e^{i\theta} + \delta\!\left(\overline{r}\right) \qquad [11]$$

For the intensity one can obtain

$$I\!\left(\overline{r},\theta\right) = \left(\left\langle \psi\!\left(\overline{r}\right)\right\rangle e^{i\theta} + \delta\!\left(\overline{r}\right)\right)\!\left(\left\langle \psi\!\left(\overline{r}\right)\right\rangle^{*} e^{-i\theta} + \delta^{*}\!\left(\overline{r}\right)\right) \qquad [12]$$

yielding

$$I\!\left(\overline{r},\theta\right) = \left|\left\langle \psi\!\left(\overline{r}\right)\right\rangle\right|^{2} + \left|\delta\!\left(\overline{r}\right)\right|^{2} + 2\cos\theta R_{e}\!\left(\left\langle \psi\right\rangle^{*}\delta\right) + 2\sin\theta I_{m}\!\left(\left\langle \psi\right\rangle^{*}\delta\right) \qquad [13]$$

If the intensity is integrated with a weighted cosine and sine function of θ, we obtain respectively

$$\left\langle I_{1}\!\left(\overline{r}\right)\right\rangle = \int_{0}^{2\pi} I(\theta)\cos\theta d\theta = \mathrm{Re}\!\left(\left\langle \psi\right\rangle^{*}\delta\right) \qquad [14]$$

$$\left\langle I_{2}\!\left(\overline{r}\right)\right\rangle = \int_{0}^{2\pi} I(\theta)\sin\theta d\theta = \mathrm{Im}\!\left(\left\langle \psi\right\rangle^{*}\delta\right) \qquad [15]$$

In a real experiment, this can be done by, for each phase, keeping the phase θ constant while recording image intensity data during a time proportional to cos θ respectively sin θ. In practice, since one cannot record with negative weighting functions, integration in two steps will be required in combination with subtracting of the results afterwards.

$$\left\langle I_{2}\!\left(\overline{r}\right)\right\rangle = \int_{0}^{\pi} I(\theta)\sin\theta d\theta - \left[-\int_{\pi}^{2\pi} I(\theta)\sin\theta d\theta\right] \qquad [16]$$

(idem for $\langle I_{1}(r)\rangle$).

Now one can reconstruct the wavefunction based on $\langle I_{1}(\overline{r})\rangle$ and $\langle I_{2}(\overline{r})\rangle$ and $\langle \Psi\rangle$ and $(\delta)$ can be separated using a high pass filter. The latter illustrates how wave function data, in the present example being the whole wave function, can be extracted from electron microscopy using a variable phase inducing means, further indicating optional features and advantages of embodiments of the present invention. Note that the method does not make any assumptions of the relative values of $\langle \Psi\rangle$ and $(\delta)$ and can thus be used even for strongly scattering objects.

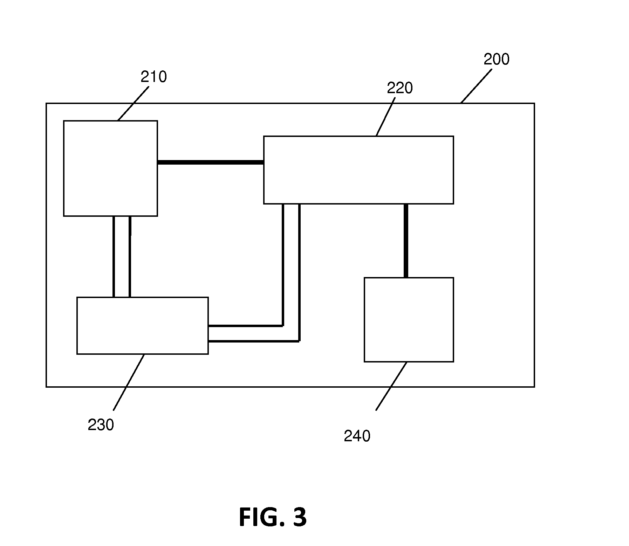

In a second aspect, the present invention also relates to an image processing system for obtaining wave function data. The image processing system according to embodiments of the present invention comprises an input port adapted for receiving microscope image intensity data, e.g. electron microscope image intensity data, acquired using a variable phase inducing means, e.g. a phase plate, whereby the data takes into account image intensity data recorded for a plurality of different phases induced by the variable phase inducing means. The image processing system also comprises a processor for extracting wave function data from the image intensity data. The received data may be obtained in weighted form, i.e. for each phase a weighting factor may be applied to the corresponding image intensity data, or the processor may be adapted for applying a weighting factor to the different image intensity data. The image processor furthermore may comprises components performing the functionality as expressed by one or more features of the method for obtaining wave function data as described above. The image processing system may be adapted for performing a method as described in the first aspect in an automated and/or automatic way. The image processing system may be implemented in a software manner or as dedicated hardware. The processor may operate according to a predetermined algorithm. It may make use of predetermined instructions, look up tables, etc. By way of illustration, embodiments of the present invention not being limited thereto, an example of an image processing system 200 comprising an input port 210 and a processor 220 as described above is shown in FIG. 3. The processor 220 may be adapted for extracting the wave function data and optionally also for combining data. The system furthermore typically may comprise a memory 230 for temporarily storing data and an output means 240 for outputting the obtained results. The latter may be by displaying the results e.g. on a display, plotter, printer, etc. or it may be by outputting data signals, e.g. through an output port.

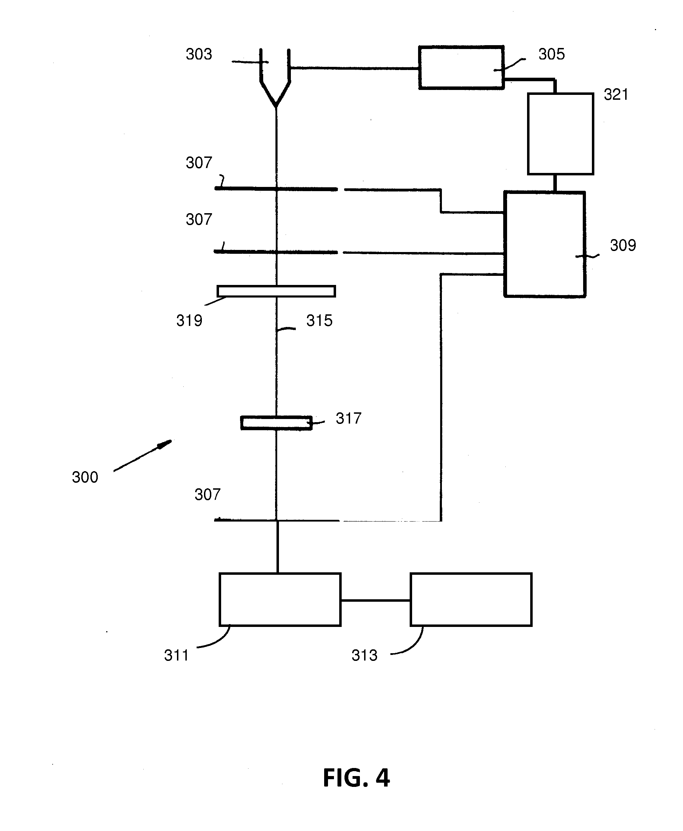

In one aspect, the present invention also relates to a transmission electron microscope for obtaining electron microscopy images. The transmission electron microscope according to embodiments of the present invention comprises a variable phase inducing means for inducing a phase shift in an aperture of the variable phase inducing means over a phase shift angle and a controller for controlling acquisition of electron microscope image intensity data recorded taking into account image intensity data recorded for the plurality of different phases induced by the variable phase inducing means. The electron microscope furthermore comprises an image processing system as described in the second aspect. By way of illustration, the present invention not being limited thereto, an example of a transmission electron microscope is shown in FIG. 4. A high-resolution electron microscope 300 is shown comprising an electron source 303 which is fed by a high-voltage generator 305, and also comprises a number of lenses307 which are fed by a lens power supply source 309. The electron microscope 301 also comprises a detection system 311, the detected information being applied to the image processing system 313. The electron beam 315 is incident on an object 317. High-resolution images of the object 317 can be recorded. According to embodiments of the present invention, the electron microscope 300 also comprises a variable phase inducing means 319, such as for example a variable electrostatic phase plate, a set of phase plates that can be altered depending on the phase required, etc. The electron microscope 300 also comprises a controller 321 for controlling the imaging. Further features and advantages may be as expressed in other aspects of the present invention. Embodiments according to the present invention also encompass optical coherent microscope having corresponding components as described above.

In one aspect, embodiments of the present invention also relate to computer-implemented methods for obtaining wave function data based on an image obtained in an electron microscope using a variable phase inducing means. Embodiments of the present invention also relate to corresponding computer program products. The methods may be implemented in a computing system. They may be implemented as software, as hardware or as a combination thereof. Such methods may be adapted for being performed on computer in an automated and/or automatic way. In case of implementation or partly implementation as software, such software may be adapted to run on suitable computer or computer platform, based on one or more processors. The software may be adapted for use with any suitable operating system such as for example a Windows operating system or Linux operating system. The computing means may comprise a processing means or processor for processing data. According to some embodiments, the processing means or processor may be adapted for processing image data obtained in an electron microscope using a variable phase inducing means according to any of the methods as described above. Besides a processor, the computing system furthermore may comprise a memory system including for example ROM or RAM, an output system such as for example a CD-rom or DVD drive or means for outputting information over a network. Conventional computer components such as for example a keybord, display, pointing device, input and output ports, etc also may be included. Data transport may be provided based on data busses. The memory of the computing system may comprise a set of instructions, which, when implemented on the computing system, result in implementation of part or all of the standard steps of the methods as set out above and optionally of the optional steps as set out above. The obtained results may be outputted through an output means such as for example a plotter, printer, display or as output data in electronic format.

Further aspect of embodiments of the present invention encompass computer program products embodied in a carrier medium carrying machine readable code for execution on a computing device, the computer program products as such as well as the data carrier such as dvd or cd-rom or memory device. Aspects of embodiments furthermore encompass the transmitting of a computer program product over a network, such as for example a local network or a wide area network, as well as the transmission signals corresponding therewith.

While the invention has been illustrated and described in detail in the drawings and foregoing description, such illustration and description are to be considered illustrative or exemplary and not restrictive. It will be appreciated, however, that no matter how detailed the foregoing appears in text, the invention may be practiced in many ways, and is therefore not limited to the embodiments disclosed.

Other variations to the disclosed embodiments can be understood and effected by those skilled in the art in practicing the claimed invention, from a study of the drawings, the disclosure and the appended claims.

In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage.

Any reference signs in the claims should not be construed as limiting the scope.

It should be noted that the use of particular terminology when describing certain features or aspects of the invention should not be taken to imply that the terminology is being re-defined herein to be restricted to include any specific characteristics of the features or aspects of the invention with which that terminology is associated.

**Claims**

1. A method for obtaining wave function data from microscope measurements, the method comprising

   - receiving microscope image intensity data acquired using a variable phase inducing means, the microscope image intensity data taking into account a image intensity data recorded for a plurality of different induced phases, and
   - extracting wave function data from the microscope image intensity data.

2. A method according to claim 1, wherein the microscope image intensity data are electron microscope image intensity data.

3. A method according to any of claims 1 to 2, the received microscope image intensity data comprising image intensity data recorded for a plurality of different induced phases, wherein said extracting comprises first combining the plurality of image intensity data recorded for different induced phases.

4. A method according to any of claims 1 to 3, wherein extracting wave function data comprises deriving the wave function data from the microscope image intensity data by distinguishing a component related to the variable phase inducing means from a component comprising the wave function data.

5. A method according to claim 4, wherein the component related to the variable phase inducing means is a component being function of an aperture function of the phase inducing means.

6. A method according to any of claims 1 to 5, wherein extracting wave function data is obtained by applying a high pass filter on the acquired image intensity data.

7. A method according to any of the previous claims, wherein receiving microscope image intensity data acquired using a variable phase inducing means comprises receiving, for each phase, image intensity data weighted by applying a phase dependent image intensity recording time.

8. A method according to claim 7, wherein the image recording times are goniometric functions of the phase shift angle $\theta$ induced by the variable phase inducing means.

9. A method according to any of the previous claims, wherein receiving microscope image intensity data comprises acquiring transmission microscope image intensity data using a variable phase inducing means.

10. A method according to claim 8, wherein the phase inducing means is a variable electrostatic phase plate.

11. An image processing system for extracting wave function data, the image processing system comprising

    - an input port adapted for receiving microscope image intensity data acquired using a variable phase inducing means, the microscope image intensity data taking into account image intensity data for a plurality of different phases, and
    - a processor adapted for extracting wave function data from the microscope image intensity data acquired.

12. An image processing system wherein the microscope image intensity data is electron microscope image intensity data.

**13.** A transmission electron microscope for obtaining electron microscope images, the transmission electron microscope comprising

- a variable phase inducing means for inducing a variably settable phase shift in an aperture of the variable phase inducing means over a phase shift angle ,
- a controller for controlling acquisition of electron microscope image intensity data using a variable phase inducing means, the electron microscope image intensity data taking into account image intensity data for a plurality of different induced phases, and
- an image processing system according to claim 11.

**14.** A computer program product for performing, when implemented on a computing device, a method according to any of claims 1 to 10.

**15.** A machine readable data storage device storing the computer program product of claim 14.

100

Receiving electron microscope image intensity data acquired using a variable phase inducing means

110

Extracting wave function data

Combining image data obtained for a plurality of different, induced phases

120

130

Outputting obtained wave function data or exit wave data and/or using the data for other electron microscopy image processing

140

**FIG. 1**

0         ⟶   g

**FIG. 2**

**FIG. 3**

303

305

321

307

307

309

319

315

317

300

307

311

313

**FIG. 4**

Europäisches
Patentamt

European
Patent Office

Office européen
des brevets

# EUROPEAN SEARCH REPORT

Application Number

EP 09 17 0780

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,X | HSIEH ET AL.: "Contrast Transfer Function Design by an Electrostatic Phase Plate" MICROSC. MICROANAL., vol. 13, 2007, pages 1216-1217, XP002566105 * the whole document * | 1-6,9, 11-15 | INV. H01J37/26 |
| X | US 5 969 855 A (ISHIWATA HIROSHI [JP] ET AL) 19 October 1999 (1999-10-19) * abstract; claim 1; figures 1,7,9,10 * * column 1, lines 1-10 * * column 3, lines 4-67 * * column 6, line 39 - column 7, line 53 * * column 8, lines 60-66 * * column 13, line 29 - column 14, line 37 * | 1,3-11, 14,15 | |
| X | ALLOYEAU D ET AL: "New developments in phase Contrast Transmission Electron Microscopy with Electrostatic Phase Plate" MICROSCOPY AND MICROANALYSIS, SPRINGER, NEW YORK, NY, US, vol. 15, no. suppl. 2, 1 July 2009 (2009-07-01), pages 1086-1087, XP009128472 ISSN: 1431-9276 * the whole document * | 1 | |

-/--

TECHNICAL FIELDS
SEARCHED (IPC)

H01J
G01N

The present search report has been drawn up for all claims

| Place of search | Date of completion of the search | Examiner |
|---|---|---|
| Munich | 29 January 2010 | Giovanardi, Chiara |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 2 299 468 A1

Europäisches
Patentamt

European
Patent Office

Office européen
des brevets

## EUROPEAN SEARCH REPORT

Application Number

EP 09 17 0780

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SATO KAZUHISA ET AL: "Atomic structure imaging of L10-type FePd nanoparticles by spherical aberration corrected high-resolution transmission electron microscopy" JOURNAL OF APPLIED PHYSICS, AMERICAN INSTITUTE OF PHYSICS. NEW YORK, US, vol. 105, no. 3, 9 February 2009 (2009-02-09), pages 34308-34308, XP012119778 ISSN: 0021-8979 * pages 034308-3, column 2, lines 27-33,40-59; figure 3 * | 1 | |
| A | KUNIAKI NAGAYAMA, RADOSTIN DANEV: "Phase-plate electron microscopy: a novel imaging tool to reveal close-to-life nano-structures" BIOPHYS. REV, vol. 1, no. 1, 17 January 2009 (2009-01-17), pages 37-42, XP002566106 * page 37 * | | TECHNICAL FIELDS SEARCHED (IPC) |

The present search report has been drawn up for all claims

| Place of search | Date of completion of the search | Examiner |
|---|---|---|
| Munich | 29 January 2010 | Giovanardi, Chiara |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

15

**ANNEX TO THE EUROPEAN SEARCH REPORT
ON EUROPEAN PATENT APPLICATION NO.**

EP 09 17 0780

This annex lists the patent family members relating to the patent documents cited in  the above-mentioned European search report.
The members are as contained in the European Patent Office EDP file on
The European Patent Office is in no way liable for these particulars which are merely given for the purpose of information.

29-01-2010

| Patent document cited in search report | | Publication date | Patent family member(s) | Publication date |
|---|---|---|---|---|
| US 5969855 | A | 19-10-1999 | NONE | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Hsieh et al.** Contrast Transfer Function Design by an Electrostatic Phase Plate. *Microsc. Microanal,* 2007, vol. 13

- **Nagayama et al.** *Biophys. Rev.,* 2009, 37-42